# EUROPEAN PATENT APPLICATION

(11) **EP 4 641 411 A1**
(43) Date of publication of application: **29.10.2025**
(21) Application number: 23932683.8
(22) Date of filing: 14.08.2023
(51) Int. Cl.: G06F 18/2433, G01R 31/367, G01R 31/3842, G01R 31/396, G06F 18/27, G06F 18/15

(54) **BATTERY CELL ANOMALY DETERMINATION METHOD AND SYSTEM, PROCESSING DEVICE, AND STORAGE MEDIUM**

(30) Priority: 14.04.2023 CN 202310419998
(71) Applicant: Hefei Gotion High-Tech Power Energy Co., Ltd., Hefei, Anhui 230011 (CN)
(72) Inventor: FANG, Ziyu, Hefei, Anhui 230011 (CN); HU, Liang, Hefei, Anhui 230011 (CN); JIANG, Song, Hefei, Anhui 230011 (CN); GAO, Fei, Hefei, Anhui 230011 (CN); LUO, Dazhi, Hefei, Anhui 230011 (CN)
(74) Representative: Winter, Brandl - Partnerschaft mbB
(86) International application number: PCT/CN2023/112797
(87) International publication number: WO 2024/212410

(57) **Abstract**

The present invention relates to a battery cell anomaly determination method and system, a processing device, and a storage medium. The method comprises: obtaining time-series of real physical data of each cell in a battery pack to be detected, performing preprocessing, inputting the preprocessed time-series of real physical data into a pre-constructed cell anomaly determination model, and calculating to obtain physical data predicted values of a plurality of frames of each cell in the battery pack to be detected; according to the physical data predicted values of the plurality of frames of each cell and physical data true values of corresponding frames, calculating to obtain difference features of the plurality of frames of each cell in the battery pack to be detected; integrating and summarizing the difference features of the plurality of frames of each cell to obtain an anomaly sorting result of each cell; and determining the serial number of an anomalous cell in the battery pack to be detected according to the anomaly sorting result of each cell and a preset threshold. According to the method, the fault of a battery cell can be predicted in advance, and the method can be widely used in the technical field of battery fault detection.

## Description

### Technical Field

The present invention relates to the technical field of battery fault detection, in particular to a battery cell anomaly determination method and system, a processing device, and a storage medium.

### Background Art

For an electric vehicle, it is necessary to form a battery pack by connecting battery cells in a way of serial connection to meet a power demand in a process of vehicle running. Due to influences from various uncontrollable factors during manufacture and use of the battery pack, differences among the battery cells will arise, and thus, the power performance of the battery pack is lowered. At present, there has been the prior art that an operation situation of single cell is traced according to historical data of each cell in a battery pack on a big data cloud platform, and then, a fault of a power battery pack is determined.

However, a battery management system (BMS) and an in-vehicle infotainment system can only determine a fault according to collected information, but cannot trace to the source of the fault through the big data.

### Summary of the Invention

For solving the above-mentioned problems, the object of the present invention is to provide a battery cell anomaly determination method and system, a processing device, and a storage medium, that can predict battery fault symptoms in advance.

In order to achieve the above-mentioned object, the present invention adopts the following technical solutions: in a first aspect, provided is a battery cell anomaly determination method, including:
obtaining time-series of real physical data of each cell in a battery pack to be detected, performing preprocessing, inputting the preprocessed time-series of real physical data into a pre-constructed cell anomaly determination model, and calculating to obtain physical data predicted values of a plurality of frames of each cell in the battery pack to be detected;
according to the physical data predicted values of the plurality of frames of each cell and physical data true values of corresponding frames, calculating to obtain difference features of the plurality of frames of each cell in the battery pack to be detected;
integrating and summarizing the difference features of the plurality of frames of each cell to obtain an anomaly sorting result of each cell; and
determining the serial number of an anomalous cell in the battery pack to be detected according to the anomaly sorting result of each cell and a preset threshold.

Further, a process of constructing the cell anomaly determination model includes:
obtaining the time-series of real physical data of each cell in the battery;
preprocessing the obtained time-series of real physical data; and
selecting a model consistent with a process of the preprocessed time-series of real physical data, determining model parameters, and constructing and training a cell anomaly determination model according to the preprocessed time-series of real physical data to obtain a trained cell anomaly determination model.

Further, the cell anomaly determination model is an ARIMA (Autoregressive Integrated Moving Average) model, inputs of the cell anomaly determination model are first n frames of the preprocessed time-series of real physical data, and outputs of the cell anomaly determination model are physical data predicted values of last m frames on the time series of each cell in the battery.

Further, the obtaining time-series of real physical data of each cell in a battery pack to be detected, performing preprocessing, inputting the preprocessed time-series of real physical data into a pre-constructed cell anomaly determination model, and calculating to obtain physical data predicted values of a plurality of frames of each cell in the battery pack to be detected includes:
obtaining the time-series of real physical data of each cell in the battery pack to be detected;
preprocessing the obtained time-series of real physical data; and
inputting first n frames of the preprocessed time-series of real physical data into the pre-constructed cell anomaly determination model, and calculating to obtain physical data predicted values of last m frames on the time series of each cell in the battery pack to be detected. Further, the preprocessing includes data cleaning, stationarity test and white noise test.

Further, the according to the physical data predicted values of the plurality of frames of each cell and physical data true values of corresponding frames, calculating to obtain difference features of the plurality of frames of each cell in the battery pack to be detected includes:
according to physical data predicted values of last m frames on the time series of each cell in the battery pack to be detected and physical data true values of last m frames in the obtained time-series of real physical data, calculating to obtain the difference features of the plurality of frames of each cell in the battery pack to be detected.

Further, the integrating and summarizing the difference features of the plurality of frames of each cell to obtain an anomaly sorting result of each cell includes:
performing time series nonlinear regression fitting on the difference features of the plurality of frames of each cell in the battery pack to be detected, to generate an entire anomaly feature of the battery pack to be detected; and
sorting the difference features of the plurality of frames of each cell in the battery pack to be detected according to the generated anomaly feature to obtain the anomaly sorting result of each cell.

In a second aspect, provided is a battery cell anomaly determination system, including:
a predicted value calculation module configured to obtain time-series of real physical data of each cell in a battery pack to be detected, perform preprocessing, input the preprocessed time-series of real physical data into a pre-constructed cell anomaly determination model, and calculate to obtain physical data predicted values of a plurality of frames of each cell in the battery pack to be detected;
a difference feature calculation module configured to calculate to obtain difference features of the plurality of frames of each cell in the battery pack to be detected, according to the physical data predicted values of the plurality of frames of each cell and physical data true values of corresponding frames;
an anomaly sorting module configured to integrate and summarize the difference features of the plurality of frames of each cell to obtain an anomaly sorting result of each cell; and
an anomaly determination module configured to determine the serial number of an anomalous cell in the battery pack to be detected according to the anomaly sorting result of each cell and a preset threshold.

In a third aspect, provided is a processing device, including a computer program instruction, wherein the computer program instruction, when executed by the processing device, is used for implementing the corresponding steps of the above-mentioned battery cell anomaly determination method.

In a fourth aspect, provided is a computer-readable storage medium, wherein the computer-readable storage medium has a computer program instruction stored thereon, and the computer program instruction, when executed by a processor, is used for implementing the corresponding steps of the above-mentioned battery cell anomaly determination method.

Due to the adoption of the above-mentioned technical solution, the present invention has the following advantages:
1. according to the present invention, fault information of cells in the battery pack can be initially calculated and collected by directly using the pre-constructed cell anomaly determination model based on the physical data true data time series of each cell in the battery pack.
2. according to the present invention, initial symptoms of some cell faults can be identified based on the anomaly sorting result and the serial number of the anomalous cell, which has a good early warning effect for gradual fault detection.
3. according to the present invention, the serial number of the anomalous cell in the battery pack can be determined, which can achieve vehicle maintenance and battery maintenance in a process of maintaining the entire vehicle, play a role in predicting a battery fault, reduce the situations of reporting faults on the market, and improve brand competitiveness.

In conclusion, the present invention can be widely used in the technical field of battery fault detection.

### Brief Description of the Drawings

By reading detailed description for the following preferred embodiments, various other advantages and benefits will become apparent to those of ordinary skill in the art. The accompanying drawing is only intended to show the preferred embodiments, but is not regarded as a limitation on the present invention. In the entire accompanying drawing, the same numeral indicates the same component. In the accompanying drawing:

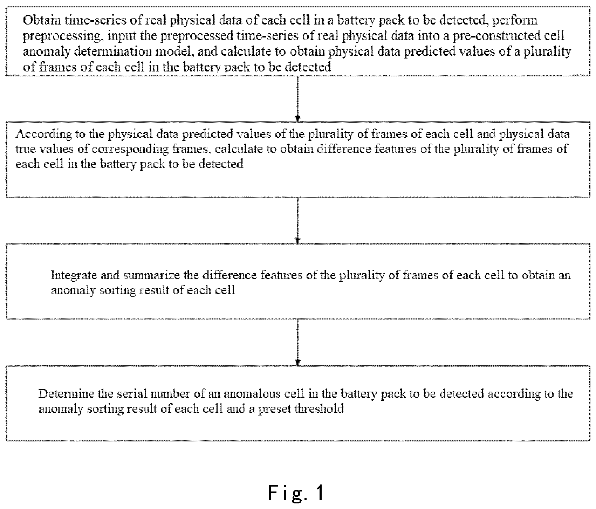

Fig. 1 is a schematic flow diagram of a method provided in an embodiment of the present invention.

### Detailed Description of the Invention

Exemplary embodiments of the present invention will be described in more detail below with reference to the accompanying drawing. Although the exemplary embodiments of the present invention are shown in the accompanying drawing, it should be understood that the present invention can be implemented in various forms, but should not be limited by the embodiments described herein. On the contrary, these embodiments are provided for understanding the present invention more thoroughly and integrally transmitting the scope of the present invention to the skilled in the art.

It should be understood that terms used herein are only intended to describe specific exemplary embodiments, rather than to perform limitation. A singular form "one", "a" or "the" used herein may also include a plural form unless it is clearly indicated in the context. Terms "include", "including", "includes" and "have" are inclusive, and therefore, they indicate the existence of stated features, steps, operations, elements and/or components, but the existence or addition of one or more other features, steps, operations, elements, components, and/or combinations thereof are not exclusive. The steps, processes and operations of the method described herein are not explained as that they must be performed in a described or illustrated specific order unless a performing order is indicated clearly. It should be further understood that alternative or substitutional steps can be used.

Although terms such as first, second and third can be used herein to describe a plurality of elements, components, areas, layers and/or sections, these elements, components, areas, layers and/or the sections should not be limited by these terms. These terms can be only used for separating one element, component, area, layer or section from another area, layer or section. Terms such as "first" and "second" and other digital terms do not imply orders or sequences when used herein unless it is clearly indicated otherwise. Therefore, a first element, component, area, layer or section discussed below may be known as a second element, component, area, layer or section without departing from enlightenment in the exemplary embodiments.

According to a battery cell anomaly determination method and system, a processing device, and a storage medium provided in embodiments of the present invention, difference features of a plurality of frames of each cell in a battery pack to be detected is initially determined by adopting a pre-constructed cell anomaly determination model, then, an anomaly sorting result of each cell is obtained according to the determined difference features, and then, the serial number of an anomalous cell in the battery pack is determined according to a preset threshold. According to the present invention, battery fault symptoms can be predicted in advance, so that battery faults are avoided, the fault rate is reduced, a battery is maintained in advance, and the brand competitiveness of the battery is enhanced.

### Embodiment 1

As shown in Fig. 1, the present embodiment provides a battery cell anomaly determination method, including the following steps:
1) a cell anomaly determination model is pre-constructed.
2) time-series of real physical data of each cell in a battery pack to be detected is obtained, preprocessing is performed, the preprocessed time-series of real physical data is inputted into the pre-constructed cell anomaly determination model, and calculation is performed to obtain physical data predicted values of a plurality of frames of each cell in the battery pack to be detected.
3) according to the physical data predicted values of the plurality of frames of each cell and physical data true values of corresponding frames, calculation is performed to obtain difference features of the plurality of frames of each cell in the battery pack to be detected.
4) the difference features of the plurality of frames of each cell are integrated and summarized to obtain an anomaly sorting result of each cell.
5) the serial number of an anomalous cell in the battery pack is determined according to the anomaly sorting result of each cell and a preset threshold.

By adopting the method in the present invention, a fault of a battery cell can be predicted in advance, and the serial number of the anomalous cell in the battery pack is determined, which has a good early warning effect for gradual fault detection, and can achieve vehicle maintenance and battery maintenance in a process of maintaining the entire vehicle, play a role in predicting a battery cell fault, reduce the situations of reporting faults on the market.

A specific process that the cell anomaly determination model is pre-constructed in the above-mentioned step 1) includes:
1.1) the time-series of real physical data of each cell in the battery is obtained.

Specifically, physical data includes voltage data, current data, insulation resistance and temperature data and other data of each cell in the battery.

Specifically, the time-series of real physical data is a time series composed of multi-frame physical data.

Specifically, relevant data is obtained by adopting a big data cloud platform, and the big data cloud platform refers to a cloud platform constructed by using a big data method and used for processing and storing power battery information.

1.2) the obtained time-series of real physical data is preprocessed.

Specifically, the preprocessing includes data cleaning, stationarity test and white noise test, and meanwhile, the balance between a differencing order and information loss should be concerned. The data cleaning refers to removing wrong information in the data and filling missing information to correct "dirty" data.

1.3) a model consistent with a process of the preprocessed time-series of real physical data is selected from known machine learning and deep learning models by adopting an autoregression moving average algorithm, model parameters are determined, and a cell anomaly determination model is constructed and trained according to the preprocessed time-series of real physical data to obtain a trained cell anomaly determination model, wherein inputs of the cell anomaly determination model are first n frames of the preprocessed time-series of real physical data, and outputs of the cell anomaly determination model are physical data predicted values of last m frames on the time series of each cell in the battery.

It should be noted that the cell anomaly determination model is an ARIMA (Autoregressive Integrated Moving Average) model, a model construction method for the ARIMA model belongs to a content disclosed in the prior art, and thus, a specific process thereof will be no longer repeated herein.

A specific process that time-series of real physical data of each cell in a battery pack to be detected is obtained, preprocessing is performed, the preprocessed time-series of real physical data is inputted into a pre-constructed cell anomaly determination model, and calculation is performed to obtain physical data predicted values of a plurality of frames of each cell in the battery pack to be detected in the above-mentioned step 2) includes:
2.1) the time-series of real physical data of each cell in the battery pack to be detected is obtained.
2.2) the obtained time-series of real physical data is preprocessed.
2.3) first n frames of the preprocessed time-series of real physical data are inputted into the pre-constructed cell anomaly determination model, and calculation is performed to obtain physical data predicted values of last m frames on the time series of each cell in the battery pack.

Specifically, a sliding-step sampling method is adopted in a process of calculating model regression values, i.e., the physical data predicted values.

Specifically, a data dimension (such as a temperature and a current) with transitive dependency is included in the calculation process.

A specific process that according to the physical data predicted values of the plurality of frames of each cell and physical data true values of corresponding frames, calculation is performed to obtain difference features of the plurality of frames of each cell in the battery pack in the above-mentioned step 3) includes:
according to physical data predicted values of last m frames on the time series of each cell in the battery pack to be detected and physical data true values of last m frames in the obtained time-series of real physical data, calculation is performed to obtain the difference features of the plurality of frames of each cell in the battery pack to be detected.

A specific process that the difference features of the plurality of frames of each cell are integrated and summarized to obtain an anomaly sorting result of each cell in the above-mentioned step 4) includes:
4.1) time series nonlinear regression fitting is performed on the difference features of the plurality of frames of each cell in the battery pack to generate an entire anomaly feature of the battery pack.
4.2) the difference features of the plurality of frames of each cell in the battery pack are sorted according to the generated anomaly feature to obtain the anomaly sorting result of each cell.

The preset threshold in the above-mentioned step 5) is a dynamic numerical value generated based on big data and regularly updated and iterated.

### Embodiment 2

The present embodiment provides a battery cell anomaly determination system, including:
a predicted value calculation module configured to obtain time-series of real physical data of each cell in a battery pack to be detected, perform preprocessing, input the preprocessed time-series of real physical data into a pre-constructed cell anomaly determination model, and calculate to obtain physical data predicted values of a plurality of frames of each cell in the battery pack to be detected;
a difference feature calculation module configured to according to the physical data predicted values of the plurality of frames of each cell and physical data true values of corresponding frames, calculate to obtain difference features of the plurality of frames of each cell in the battery pack to be detected;
an anomaly sorting module configured to integrate and summarize the difference features of the plurality of frames of each cell to obtain an anomaly sorting result of each cell; and
an anomaly determination module configured to determine the serial number of an anomalous cell in the battery pack to be detected according to the anomaly sorting result of each cell and a preset threshold.

By adopting the system in the present invention, a fault of a battery cell can be predicted in advance, and the serial number of the anomalous cell in the battery pack is determined, which has a good early warning effect for gradual fault detection, and can achieve vehicle maintenance and battery maintenance in a process of maintaining the entire vehicle, play a role in predicting a battery cell fault, reduce the situations of reporting faults on the market.

In a preferred embodiment, the system further includes a model construction model configured to pre-construct a cell anomaly determination model.

In a preferred embodiment, the predicted value calculation module is internally provided with:
a data obtaining unit configured to obtain the time-series of real physical data of each cell in the battery pack to be detected;
a data preprocessing unit configured to preprocess the obtained time-series of real physical data; and
a predicted value calculation unit configured to input first n frames of the preprocessed time-series of real physical data into the pre-constructed cell anomaly determination model, and calculate to obtain physical data predicted values of last m frames on the time series of each cell in the battery pack to be detected.

In a preferred embodiment, the anomaly sorting module is internally provided with:
an anomaly feature generation unit configured to perform time series nonlinear regression fitting on the difference features of the plurality of frames of each cell in the battery pack to be detected to generate an entire anomaly feature of the battery pack to be detected; and
a sorting unit configured to sort the difference features of the plurality of frames of each cell in the battery pack to be detected according to the generated anomaly feature to obtain the anomaly sorting result of each cell.

The system provided in the present embodiment is used for performing each of the above-mentioned method embodiments, and a specific flow and detailed content thereof refer to those in the above-mentioned embodiment so as to be no longer repeated herein.

### Embodiment 3

The present embodiment provides a processing device corresponding to the battery cell anomaly determination method provided in the present embodiment 1, and the processing device may be a processing device applicable to a client side, such as a mobile phone, a notebook computer, a tablet personal computer and a desktop computer so as to perform the method in embodiment 1.

The processing device includes a processor, a memory, a communication interface and a bus, wherein the processor, the memory and the communication interface are connected by a bus so that intercommunication is completed. The memory stores a computer program capable of operating on the processing device, and the processing device, when operating the computer program, performs the battery cell anomaly determination method provided in the present embodiment 1.

In some implementations, the memory may be a high-speed RAM (Random Access Memory), and may also include a non-volatile memory, such as at least one magnetic disk memory.

In other implementations, the processor may be a central processing unit (CPU), a digital signal processor (DSP) and various other types of general-purpose processors which are not limited herein.

In addition, logic instructions in the above-mentioned memory can be implemented in a form of a software functional unit, and can be stored in a computer-readable storage medium when sold or used as an independent product. Based on such understanding, the essences of the technical solutions of the present invention or parts thereof making contributions to the prior art or parts of the technical solutions may be embodied in a form of a software product, and the computer software product is stored in a storage medium and includes a plurality of instructions used to enable a computer device (which may be a personal computer, a server, or a network device, etc.) to perform all or parts of steps of the method in each of the embodiments of the present invention. The aforementioned storage medium includes various media capable of storing program codes, such as a U disk, a mobile hard disk, an ROM (Read-Only Memory), an RAM (Random Access Memory), a diskette, and an optical disk.

It can be understood by the skilled in the art that the structure of the above-mentioned computing device is only a partial structure relevant to the solutions of the present application, and does not constitute a limitation on a computing device to which the solutions of the present application are applied, and the specific computing device may include more or fewer components, or combine some components, or have different component layouts.

### Embodiment 4

The present embodiment provides a computer program product corresponding to the battery cell anomaly determination method provided in the present embodiment 1, and the computer program product may include a computer-readable storage medium on which a computer-readable program instruction for performing the battery cell anomaly determination method in the present embodiment 1 is loaded.

The computer-readable storage medium may be a physical device keeping and storing instructions used by an instruction execution device. The computer-readable storage medium may be, but is not limited to an electric storage device, a magnetic storage device, an optical storage device, an electromagnetic storage device, a semiconductor storage device or any combinations thereof.

An implementation principle and technical effect of the computer-readable storage medium provided in the above-mentioned embodiment are similar to those of the above-mentioned method embodiments so as to be no longer repeated herein.

The present application is described by referring to flow diagrams and/or block diagrams of the method, device (system) and computer program product according to the embodiments of the present application. It should be understood that each flow and/or block in the flow diagrams and/or block diagrams as well as a combination of flows and/or blocks in the flow diagrams and/or block diagrams may be achieved by computer program instructions. The computer program instructions may be provided to a general-purpose computer, a special-purpose computer, an embedded processor or processors of other programmable data processing devices to generate a machine, so that an apparatus for achieving functions specified in one or more flows in the flow programs and/or one or more blocks in the block diagrams is generated through the instructions executed by the computer or the processors of other programmable data processing devices.

These computer program instructions may also be stored in a computer-readable memory capable of guiding the computer or other programmable data processing devices to work in a specific way, so that the instructions stored in the computer-readable memory generate a product including an instruction apparatus, and the instruction apparatus achieves the functions specified in the one or more flows in the flow diagrams and/or one or more blocks in the block diagrams.

These computer program instructions may also be loaded in the computer or other programmable data processing devices, so that a series of operation steps are performed on the computer or other programmable data processing devices to generate processing achieved by the computer, and furthermore, the instructions executed on the computer or other programmable data processing devices provide steps for achieving the functions specified in the one or more flows in the flow diagrams and/or one or more blocks in the block diagrams.

Each of the above-mentioned embodiments is only intended to describe the present invention, wherein a structure, connection way and manufacturing process of each component can be changed, and any equivalent transformations and improvements performed on the basis of the technical solutions of the present invention should not be excluded from the protective scope of the present invention.

## Claims

1. A battery cell anomaly determination method, wherein it comprises:
obtaining time-series of real physical data of each cell in a battery pack to be detected, performing preprocessing, inputting the preprocessed time-series of real physical data into a pre-constructed cell anomaly determination model, and calculating to obtain physical data predicted values of a plurality of frames of each cell in the battery pack to be detected;
according to the physical data predicted values of the plurality of frames of each cell and physical data true values of corresponding frames, calculating to obtain difference features of the plurality of frames of each cell in the battery pack to be detected;
integrating and summarizing the difference features of the plurality of frames of each cell to obtain an anomaly sorting result of each cell; and
determining the serial number of an anomalous cell in the battery pack to be detected according to the anomaly sorting result of each cell and a preset threshold.

2. The battery cell anomaly determination method of claim 1, wherein a process of constructing the cell anomaly determination model comprises:
obtaining the time-series of real physical data of each cell in the battery;
preprocessing the obtained time-series of real physical data; and
selecting a model consistent with a process of the preprocessed time-series of real physical data, determining model parameters, and constructing and training a cell anomaly determination model according to the preprocessed time-series of real physical data to obtain a trained cell anomaly determination model.

3. The battery cell anomaly determination method of claim 1, wherein the cell anomaly determination model is an ARIMA (Autoregressive Integrated Moving Average) model, inputs of the cell anomaly determination model are first n frames of the preprocessed time-series of real physical data, and outputs of the cell anomaly determination model are physical data predicted values of last m frames on the time series of each cell in the battery.

4. The battery cell anomaly determination method of claim 1, wherein, the obtaining time-series of real physical data of each cell in a battery pack to be detected, performing preprocessing, inputting the preprocessed time-series of real physical data into a pre-constructed cell anomaly determination model, and calculating to obtain physical data predicted values of a plurality of frames of each cell in the battery pack, comprises:
obtaining the time-series of real physical data of each cell in the battery pack to be detected;
preprocessing the obtained time-series of real physical data; and
inputting first n frames of the preprocessed time-series of real physical data into the pre-constructed cell anomaly determination model, and calculating to obtain physical data predicted values of last m frames on the time series of each cell in the battery pack to be detected.

5. The battery cell anomaly determination method of claim 2 or 4, wherein the preprocessing comprises data cleaning, stationarity test and white noise test.

6. The battery cell anomaly determination method of claim 1, wherein, the according to the physical data predicted values of the plurality of frames of each cell and physical data true values of corresponding frames, calculating to obtain difference features of the plurality of frames of each cell in the battery pack to be detected, comprises:
according to physical data predicted values of last m frames on the time series of each cell in the battery pack to be detected and physical data true values of last m frames in the obtained time-series of real physical data, calculating to obtain the difference features of the plurality of frames of each cell in the battery pack.

7. The battery cell anomaly determination method of claim 1, wherein, the integrating and summarizing the difference features of the plurality of frames of each cell to obtain an anomaly sorting result of each cell, comprises:
performing time series nonlinear regression fitting on the difference features of the plurality of frames of each cell in the battery pack to be detected, to generate an entire anomaly feature of the battery pack to be detected; and
sorting the difference features of the plurality of frames of each cell in the battery pack to be detected according to the generated anomaly feature, to obtain the anomaly sorting result of each cell.

8. A battery cell anomaly determination system, wherein it comprises:
a predicted value calculation module configured to obtain time-series of real physical data of each cell in a battery pack to be detected, perform preprocessing, input the preprocessed time-series of real physical data into a pre-constructed cell anomaly determination model, and calculate to obtain physical data predicted values of a plurality of frames of each cell in the battery pack to be detected;
a difference feature calculation module configured to calculate to obtain difference features of the plurality of frames of each cell in the battery pack to be detected according to the physical data predicted values of the plurality of frames of each cell and physical data true values of corresponding frames;
an anomaly sorting module configured to integrate and summarize the difference features of the plurality of frames of each cell to obtain an anomaly sorting result of each cell; and
an anomaly determination module configured to determine the serial number of an anomalous cell in the battery pack to be detected according to the anomaly sorting result of each cell and a preset threshold.

9. A processing device, comprising a computer program instruction, wherein the computer program instruction, when executed by the processing device, is used for implementing the corresponding steps of the battery cell anomaly determination method of any one of claims 1 to 7.

10. A computer-readable storage medium, wherein the computer-readable storage medium has a computer program instruction stored thereon, and the computer program instruction, when executed by a processor, is used for implementing the corresponding steps of the battery cell anomaly determination method of any one of claims 1 to 7.
